Europäisches Patentamt

European Patent Office

Office européen des brevets

(11) Publication number: **0 212 910**
A2

# (12) EUROPEAN PATENT APPLICATION

(21) Application number: 86306055.4

(22) Date of filing: 06.06.86

(51) Int. Cl.⁴: **C 23 C 16/30, H 01 L 21/205**

(30) Priority: 09.08.85 US 764299

(43) Date of publication of application: 04.03.87 Bulletin 87/10

(84) Designated Contracting States: **AT BE CH DE FR GB IT LI LU NL SE**

(71) Applicant: STAUFFER CHEMICAL COMPANY, Westport Connecticut 06881 (US)

(72) Inventor: **Kuck, Mark A., 45 Warfield Street, Upper Montclair New Jersey 07043 (US)**
Inventor: **Baumann, John A., 112 Pine Avenue, Ossining New York 10562 (US)**
Inventor: **Gersten, Susan W., 282 North Paseo de Juan, Anaheim California 92807 (US)**

(74) Representative: **Froud, Clive et al, Elkington and Fife High Holborn House 52/54 High Holborn, London WC1V 6SH (GB)**

(54) **Method and apparatus for the chemical vapour deposition of III-V semiconductors utilizing organometallic and elemental pnictide sources.**

(57) A method of chemical vapour deposition characterised in that it comprises:

(A) producing a first gas stream comprising a Group III organometallic gas and a carrier gas;

(B) producing a second gas stream comprising an elemental Group V metal gas from an elemental source and a carrier gas; and

(C) supplying said gas streams to a reactor where they react to form a III-V semiconductor;
and, optionally

(D) supplying hydrogen gas to said reactor is disclosed.

A chemical vapour deposition apparatus characterised in that it comprises:

(A) first means (8) for producing a first gas stream comprising a Group III organometallic gas and a carrier gas;

(B) second means (6) for producing a second gas stream comprising an elemental Group V metal gas from an elemental source and a carrier gas; and

(C) a reactor (4) to which said gas streams are supplied where they react to form a III-V semiconductor; and, optionally,

(D) third means for supplying hydrogen gas to said reactor is also disclosed.

The present invention provides advantages over the prior art.

The arsine, phosphine and trimethyl triethyl, or trialkyl arsine or trialkyl phosphine adducts of triethyl or trimethyl indium sources of the prior art are replaced by one or more pnictide (Group V) bubblers; that is, heated sources of elemental pnictides through which a carrier gas is allowed to flow. The el-

ACTORUM AG

emental pnictide gas and the carrier gas are supplied in a stream as are a Group III organometallic gas, a carrier gas, and hydrogen to a chemical vapour deposition reactor where they react to form III-V semiconductors surface layers on a substrate. The carrier gas may be nitrogen, or a noble gas, such as argon. Alternatively, hydrogen may be used as the carrier gas so that the reaction is carried out in an exclusive hydrogen atmosphere. At least some of this hydrogen may be monoatomic hydrogen. The substrate may be a III-C semiconductor or glass. Products include layers of gallium arsenide, indium phosphide and alloys thereof, including gallium indium arsenide and gallium aluminium arsenide. Other ternary and quaternary III-V semiconductors are produced using appropriate combinations of sources of Group III organometallic gases and Group V elemental gases produced by bubblers. The products may be used in semiconductor devices including solar cells.

"Method and apparatus for the chemical vapour deposition of III-V semiconductors utilizing organometallic and elemental pnictide sources"

This invention relates to a method and apparatus for the chemical vapour deposition of III-V semiconductors utilizing organometallic and elemental pnictide sources.

More particularly, the present invention relates to organometallic chemical vapour deposition (OMCVD); to the preparation of III-V semiconductors and surface layers; to binary, ternary and quaternary III-V semiconductors; and to sources of elemental pnictide gases. It also relates to the production of electronic semiconductor devices, electro-optical devices and thin films.

For further information, reference may be made to, for example, EP-A-152668, 152669, 153526 and 154072.

All reported commercial organometallic chemical vapour deposition (OMCVD) processes for the preparation of III-V semiconductors involve the use of phosphine or arsine as the pnictide (Group V) source. These materials are highly toxic and present difficulties in handling the sources, in the process, and in the residual gases produced that contain the toxic gases.

The preparation of III-V semiconductors via organometallic chemical vapour deposition (OMCVD) also has been plagued by the reactivity of the indium source, trimethyl indium (TMI) or triethyl indium (TEI), with the Group V hydrides, $PH_3$ and $AsH_3$. Undesirable polymer formation is especially pronounced in the growth of indium compounds including arsenides, phosphides and antimonides using either TMI or especially TEI. Problems have been reported in growing gallium indium arsenide due to the "parasitic" reactions of TMI with arsine.

These problems may be circumvented by the utilization of the trialkyl phosphine adduct of TMI $((CH_3)_3InP(C_2H_5)_3)$. By thus preventing the reaction of the Lewis acid (TMI) with arsine in the vapour phase, good quality GaInAs may be prepared.

Others have reported that they have overcome the problem of growth of $Ga_xIn_{1-x}As$ alloys lattice-matched to InP substrates by using trimethyl arsine (TMAs) in place of arsine. Cooper also has been successful in making quaternary $Al_xGa_yIn_{1-x-y}As$ layers over a wide range of solid compositions on GaAs substrates using TMAs as the arsenic source.

InP may be produced by using the triethyl phosphine $((C_2H_5)_3P)$ adduct of trimethyl indium $((CH_3)_3In)$. This volatile adduct is transported to the hot substrate where it reacts with the phosphine to form InP. The dissociated $(C_2H_5)_3P$ is carried out of the reactor and does not provide a source for the phosphorus which ends up in the InP epilayer. Hence, the role of the $(C_2H_5)_3P$ is to prevent reaction of $PH_3$ with $R_3In$ before it is transported to the hot region near the substrate.

Others have avoided the problem of the "premature" reaction of $R_3In$ with $PH_3$ by the use of a phosphine pyrolysis oven which, operating at 760°C, converts the phosphine to a mixture of $P_4 + H_2$ before injection into the reactor. Hydrogen is used as the carrier gas. The preparation of device-quality homoepitaxial InP layers by this process has been reported. $P_4$ in the reactor prevents degradation of the InP surface during thermal treatment.

The problems encountered in using arsine in the preparation of III-V materials containing indium have been demonstrated. One solution is the use of the organo-arsenic compound, trimethyl arsine, as the arsenic source. The major problem with this approach is the fact that there presently is no commercial source of high purity trimethyl arsine.

Means have now been found to overcome the problems involved with the use of highly toxic arsine and phosphine and the problems involved in obtaining high purity pnictide compounds, such as trimethyl arsine, or the requirement of the use of adducts of organoindium compounds. Pnictide bubblers are used as the sources of elemental pnictide (Group V) gases in a carrier gas together with organometallic sources of Group III compounds in carrier gas, such as $N_2$ or $Ar_2$. The Group III and Group V gases are supplied to a conventional chemical vapour deposition reactor together with hydrogen gas where they react to form III-V semiconductors. Alternatively, hydrogen may be used as the carrier gas. Preferably such an all hydrogen atmosphere would provide monoatomic hydrogen at the reaction surface.

It is an object of the present invention to provide III-V semiconductor materials.

Another object of the present invention is to eliminate the use of arsine and phosphine in the production of such materials.

A further object of the present invention is to eliminate the use of pnictide compounds in the production of such materials.

The present invention provides a method of chemical vapour deposition characterised in that it comprises:

(A)     producing a first gas stream comprising a Group III organometallic gas and a carrier gas;

(B)     producing a second gas stream comprising an elemental Group V metal gas from an elemental source and a carrier gas; and

(C)     supplying said gas streams to a reactor where they react to form a III-V semiconductor;

and optionally,

(D)     supplying hydrogen gas to said reactor.

There may be at least two said first streams and/or at least two said second streams. The said second stream may be formed by bubbling the carrier gas through an elemental pnictide. If desired, said hydrogen gas may be supplied in said first gas stream. The preferred Group V metals are arsenic and phosphorus. Preferably, the said organometallic gas is of a gallium or indium compound. Triethylated Group III compounds may be used. Examples include triethyl gallium or triethyl indium. When more than one said first streams are used, one of the organometallic gases may be of an aluminium compound. The carrier gas may be nitrogen or hydrogen, at least some of which may be monoatomic.

As an example of a typical product, there may be mentioned GaAs, commonly in the form of a thin film.

The present invention also provides a chemical vapour deposition apparatus characterised in that it comprises:

(A)   first means for producing a first gas stream comprising a Group III organometallic gas and a carrier gas;

(B)   second means for producing a second gas stream comprising an elemental Group V metal gas from an elemental source and a carrier gas; and

(C)   a reactor to which said gas streams are supplied where they react to form a III-V semiconductor;

and, optionally,

(D)   third means for supplying hydrogen gas to said reactor.

There may be at least two said first means and/or at least two said second means. The said second means may comprise a pnictide bubbler. The said third means may add hydrogen gas to said first stream.

For a fuller understanding of the present invention reference may be made to the accompanying illustrative drawings wherein

Figure 1 is a schematic diagram of apparatus employing the method according to the present invention; and

Figure 2 is a schematic cross-section of a semiconductor layer on a substrate produced according to the present invention.

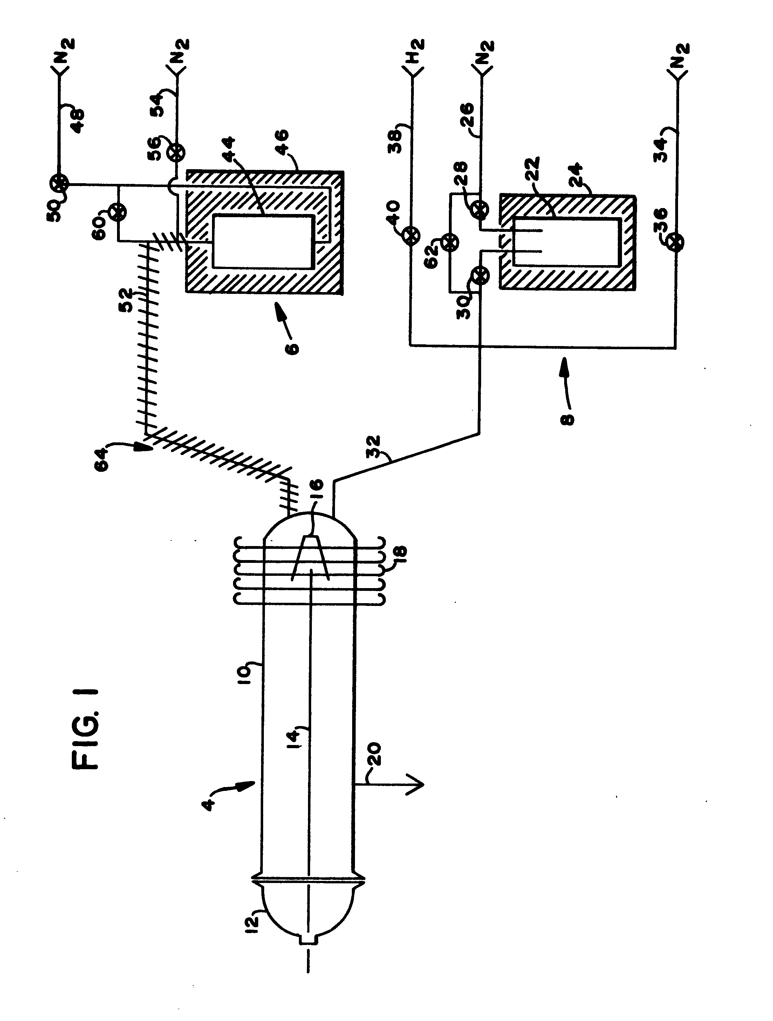

Apparatus according to the present invention for chemical vapour deposition is illustrated in accompanying Figure 1. It comprises a reactor vessel, generally indicated at 4, an elemental pnictide bubbler source generally indicated at 6 and an organometallic Group III bubbler source generally indicated at 8.

The reactor 4 is conventional as is the organometallic Group III source 8. The pnictide (Group V) source 6 is constructed in accordance with the above-mentioned related disclosures EP-A-152668, 152669 and 154072.

The conventional chemical vapour deposition reactor vessel 4 may be formed of inert material such as quartz and comprises an elongated tube 10 and a cap 12 sealed thereto. Cap 12 supports a rod 14 having a substrate holder 16 at the end thereof. The substrate holder 16 and the substrate therein (not shown) are heated by the RF heater coil 18. A thermocouple (not shown) monitors the temperature of the substrate within the substrate holder 16. The reactor vessel 4 is provided with a exhaust tube schematically indicated at 20.

The organometallic source 8 is conventional and comprises a vessel 22 for containing the organometallic material, such as trimethyl gallium or trimethyl indium, which are in liquid or solid form. The vessel 22 is surrounded by a constant temperature bath 24. Carrier gas is supplied on line 26 through metering valve 28 and bubbles through the appropriate trimethyl Group III compound in the vessel 22. The resulting gaseous trimethyl compound is carried by the carrier stream through metering valve 30 and line 32 to the reactor 4. Additional carrier gas dilutant is supplied on line 34 through shutoff valve 36 to line 32. Hydrogen gas is supplied on line 38 through shutoff valve 40 to line 32, unless hydrogen is used as the carrier gas. Flows to the lines 26, 34 and 38 and thus the total flow in line 32 are controlled by metering valves (not shown) upstream of the shutoff valves. Pnictide$_4$ gas (e.g. P$_4$ or As$_4$) is supplied to reactor 4 from the pnictide source 6 constructed in accordance with the above-mentioned references. It comprises a vessel 44 surrounded by a constant temperature bath or furnace 46 for liquid white phosphorus or granular arsenic, depending upon the product desired. White phosphorus prepared in accordance with above-mentioned EP-A-154072 is preferred. Carrier gas is bubbled through the pnictide in the vessel 44 and is supplied on line 48 through shutoff valve 50; the exiting pnictide and carrier gases being carried on line 52 to the reactor 4. Additional dilutant carrier gas is supplied on line 54 through shutoff valve 56. Flows to the lines 48 and 54 are thus the total flow in line 52 are controlled by metering valves (not shown) upstream of the shutoff valves.

Both sources 6 and 8 are termed "bubblers" in that the carrier gas, e.g. nitrogen, argon or hydrogen, is bubbled through the appropriate liquid or granular solid in order to produce the reaction gases mixed with the carrier gas. In each case, the bubblers are provided with a bypass valve 60 and 62 so that gas flows may be established prior to the initiation of the "bubbling" process.

For example, there has been demonstrated the chemistry of the process which produces growth of GaAs on a GaAs substrate or glass

$$Ga(CH_3)_3(g) + 1/4 \ As_4 \ (g) \xrightarrow{[N_2/H_2]} GaAs(s) + \text{waste gases}.$$

To produce crystalline GaAs on GaAs, liquid trimethyl gallium and powdered solid arsenic are used as sources in the "bubbler" delivery system. N$_2$ is used as the carrier gas through both the arsenic and trimethyl gallium (TMG) bubblers. Additional N$_2$ gas is added downstream of both bubblers to assist in the flow of materials to the reactors and dilute them prior to mixing. The two reactant streams are separately plumbed into the reactor wherein mixing

occurs. $H_2$ is added to the TMG flow, again, downstream of the bubbler, but prior to entrance to the reactor. The total flow is used to fix the velocities of gases through the reactor.

The TMG line is essentially at ambient temperature. The bubbler is immersed in a bath which is thermostatically controlled. The flow through the bubbler and its temperature fix the flux of TMG. In contrast, the arsenic line is heated as indicated by hatching at 64 to prevent condensation of the $As_4$ gas species generated in the arsenic bubbler. The latter is supported in a furnace. The temperature of the furnace, the flow of carrier gas through the bubbler and the geometry of the bubbler are used to fix the flux of $As_4$. The pressure in the reactor 4 is maintained in the conventional range for OMCVD of about one atmosphere.

The total flow has been varied between 1.7 and 2.9 litres/min.; the hydrogen flow has been from 14 to 22% of the total; the flow through the As bubbler has been varied from 90 to 160 ml/min., while the temperature of the As bubbler has been maintained at from 410 to 435°C. The As feed line has been maintained within 50C° of the bubbler temperature. Nitrogen flows through the TMG bubbler have varied from 1.0 to 1.5 ml/min., while the bubbler bath temperature has varied from -20 to -5°C. Substrate temperatures have been varied from 500 to 1000°C. Specific parameters for a typical run are:

$T_{sub}$=900°C, flow$_{TMG}$=1.5 ml/min.,
Temp$_{TMG}$= -19°C,
Flow As-bubbler = 160 ml/min.,
Temp As = 430°C,
Total flow = 2841 ml/min.,
$H_2$% = 20%

In preparing indium phosphide, trimethyl indium would be utilized in the organometallic source 8 and phosphorus in the phosphorus source 6. Again, hydrogen would be added to the organometallic gas stream.

Other known organometallics may be used in these processes, such as the triethyls $I_n(C_2H_5)_3$ or $Ga(C_2H_5)_3$.

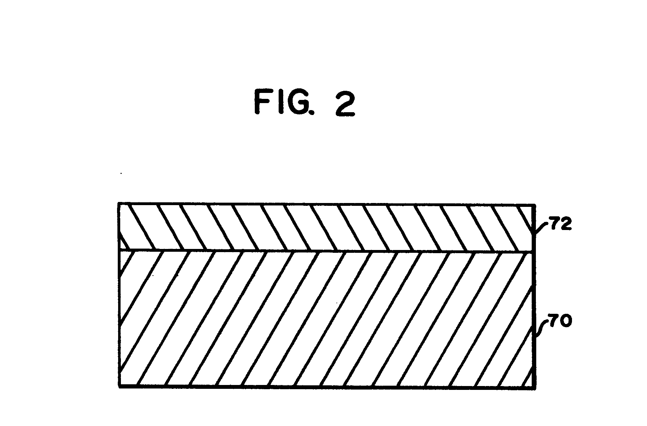

Accompanying illustrative Figure 2 shows a product of the process according to the present invention in cross-section comprising a substrate 70 on which is deposited a semiconductor layer 72 by the process according to the present invention.

There have now been successfully grown films of gallium arsenide on gallium arsenide substrates and films of gallium arsenide on Corning 7059 glass. Such may be used as solar cells, for example. Other III-V semiconductor layers, such as indium phosphide may be grown on appropriate substrates, such as indium phosphide or glass. Other binary, ternary and quaternary III-V layers may be grown by employing the appropriate elemental pnictide (Group V), e.g. phosphorus and arsenic, and Group III organometallic compounds containing gallium, indium and aluminium, in the bubblers 6 and 8 illustrated in accompanying Figure 1. If more than one Group V element is required, then two Group V bubblers, constructed as bubbler 6 illustrated in accompanying Figure 1, may be utilized. If two or more Group III components are desired in a layer, then two or more organometallic Group III bubblers, constructed as bubbler 8 illustrated in accompanying Figure 1, may be utilized.

Group III halide may also be employed in the Group III bubbler 8, such as indium monochloride or gallium trichloride.

Furthermore, hydrogen may be utilized as the carrier gas in the Group V bubbler 6 and in the Group III bubbler 8 when organometallic sources are employed.

Moreover, hydrogen may be used exclusively as the carrier gas so that the reaction in the reactor 4 is carried out in an exclusive hydrogen atmosphere. Preferably, at least some of the hydrogen would be monoatomic hydrogen obtained by cracking by means of, for example, a plasma discharge, heated filament or laser illumination.

The reactor 4 may be provided with coaxial inlets, such as disclosed in Figure 50 of U.S. Patent No. 4,508,931, for the Group III compound gases and the elemental Group V gases to facilitate proper mixing before being presented to the deposition surface.

The thickness of the films produced depend upon the period for which the reaction is carried out.  Films up to 2 microns ($\mu$m) in thickness have been produced.  Much thicker films may be made by lengthening the reaction time.

(It is to be understood that ingredients or compounds recited in the singular are intended to include compatible mixtures of such ingredients wherever the sense permits.)

Claims:

1. A method of chemical vapour deposition characterised in that it comprises:

(A) producing a first gas stream comprising a Group III organometallic gas and a carrier gas;

(B) producing a second gas stream comprising an elemental Group V metal gas from an elemental source and a carrier gas; and

(C) supplying said gas streams to a reactor where they react to form a III-V semiconductor;

and, optionally,

(D) supplying hydrogen gas to said reactor.

2. A method as claimed in claim 1 wherein there are at least two said first streams.

3. A method as claimed in claim 1 or claim 2 wherein there are at least two said second streams.

4. A method as claimed in any of claims 1 to 3 wherein said second stream is formed by bubbling the carrier gas through an elemental pnictide.

5. A method as claimed in any of claims 1 to 4 wherein said hydrogen gas is supplied in said first gas stream.

6. A method as claimed in any of claims 1 to 5 wherein said Group V metal is arsenic or phosphorus.

7. A method as claimed in any of claims 1 to 6 wherein said organometallic gas is a gallium compound or an indium compound.

8. A method as claimed in any of claims 1 to 7 wherein said organometallic gas is a triethylated Group III compound.

9.    A method as claimed in claim 7 or claim 8 wherein said compound is triethyl gallium or triethyl indium.

10.    A method as claimed in any of claims 2 to 9 wherein one of said organometallic gases is an aluminium compound.

11.    A method as claimed in any of claims 1 to 10 wherein said carrier gas is nitrogen or hydrogen, at least some of which is optionally monoatomic.

12.    A method as claimed in any of claims 1 to 11 wherein GaAs is produced, optionally in the form of a thin film.

13.    A chemical vapour deposition apparatus characterised in that it comprises:

    (A)    first means (8) for producing a first gas stream comprising a Group III organometallic gas and a carrier gas;

    (B)    second means (6) for producing a second gas stream comprising an elemental Group V metal gas from an elemental source and a carrier gas; and

    (C)    a reactor (4) to which said gas streams are supplied where they react to form a III-V semiconductor;

and, optionally,

    (D)    third means for supplying hydrogen gas to said reactor.

14.    An apparatus as claimed in claim 13 wherein there are at least two said first means.

15.    An apparatus as claimed in claim 13 or claim 14

- 12 -

0212910

wherein there are at least two said second means.

16. An apparatus as claimed in any of claims 13 to 15 wherein said second means comprises a pnictide bubbler.

17. An apparatus as claimed in any of claims 13 to 16 wherein said third means adds said hydrogen gas to said first stream.

# FIG. I

# FIG. 2

72

70